# EUROPEAN PATENT APPLICATION

(11) **EP 4 756 988 A1**
(43) Date of publication of application: **10.06.2026**
(21) Application number: 24941986.2
(22) Date of filing: 05.12.2024
(51) Int. Cl.: H01M 10/48, H01M 10/42, G01R 31/382, H01M 50/60

(54) **CELL MODULE CONTROLLER AND BATTERY DEVICE INCLUDING SAME**

(30) Priority: 29.05.2024 KR 20240070198
(71) Applicant: LG Energy Solution, Ltd., Seoul 07335 (KR)
(72) Inventor: CHOI, Jang Hyeok, Daejeon 34122 (KR); CHOI, Jongtae, Daejeon 34122 (KR)
(74) Representative: Plasseraud IP
(86) International application number: PCT/KR2024/019848
(87) International publication number: WO 2025/249678

(57) **Abstract**

A printed circuit board of a cell module controller configured to monitor a battery module is coated with a coating solution, except for an exposed area including a first point and a second point. A leakage detection circuit is formed on the printed circuit board, and includes at least one resistor connected to the first point and the second point via a line. A battery monitoring integrated circuit is formed on the printed circuit board, and receives a detection voltage at a predetermined pin, and the detection voltage is determined based on a resistance between the first point and the second point determined based on whether there is a leakage within the battery pack, and the at least one resistor.

## Description

### [Technical Field]

### CROSS-REFERENCE TO RELATED APPLICATION

This application claims priority to and the benefit of Korean Patent Application No. 10-2024-0070198 filed in the Korean Intellectual Property Office on May 29, 2024, the entire contents of which are incorporated herein by reference.

The disclosure relates to a cell module controller and a battery apparatus comprising the same.

### [Background]

An electric vehicle or a hybrid vehicle is a vehicle that obtains power by driving a motor mainly using a battery as a power supply. The electric vehicles are being actively researched because they are alternatives that can solve pollution and energy problems of internal combustion vehicles. Further, batteries are used in various external apparatuses other than the electric vehicles.

If a liquid such as coolant leaks within a battery, the insulation resistance may decrease or the battery may fire. Therefore, a battery management system uses a separate leakage detection sensor to detect the leakage. However, using the separate leakage detection sensor may increase the cost. Further, if an external leakage detection sensor is used, a battery monitoring integrated circuit may not detect the leak.

### [Disclosure]

### [Technical Problem]

Some embodiments may provide a cell module controller and a battery apparatus including the same that can detect a leakage.

### [Technical Solution]

According to some embodiments, a cell module controller configured to monitor a battery module included in a battery pack may be provided. The cell module controller may include a printed circuit board coated with a coating solution except for an exposed area including a first point and a second point, a leakage detection circuit formed on the printed circuit board and including at least one resistor connected to the first point and the second point via a line, and a battery monitoring integrated circuit formed on the printed circuit board and configured to receive a detection voltage at a predetermined pin, the detection voltage being determined based on a resistance between the first point and the second point determined based on whether there is a leakage within the battery pack, and the at least one resistor.

A battery apparatus according to some embodiments may include a battery module, a cell module controller configured to monitor the battery module, and a master battery management system configured to control the cell module controller and receive information monitored by the cell module controller. The cell module controller may include a printed circuit board coated with a coating solution except for an exposed area including a first point and a second point, a first resistor and a second resistor formed on the printed circuit board and connected in series between a terminal supplying a predetermined voltage and a terminal having a potential lower than the predetermined voltage, two terminals of the second resistor being connected to the first point and the second point, respectively, and a battery monitoring integrated circuit formed on the printed circuit board and configured to receive a voltage at a contact of the first resistor and the second resistor as a detection voltage for detecting a leakage.

### [Description of the Drawings]

FIG. 1 is a block diagram of a battery apparatus according to some embodiments.
FIG. 2 is a drawing illustrating a printed circuit board assembly of a cell module controller according to some embodiments.
FIG. 3 is a drawing illustrating a leakage detection circuit of a cell module controller according to some embodiments.
FIG. 4 is a drawing illustrating leakage detection in a battery apparatus according to some embodiments.
FIG. 5 is a drawing illustrating leakage detection in a sleep mode of a battery apparatus according to some embodiments.
FIG. 6 is a diagram illustrating a printed circuit board assembly of a cell module controller according to some embodiments.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

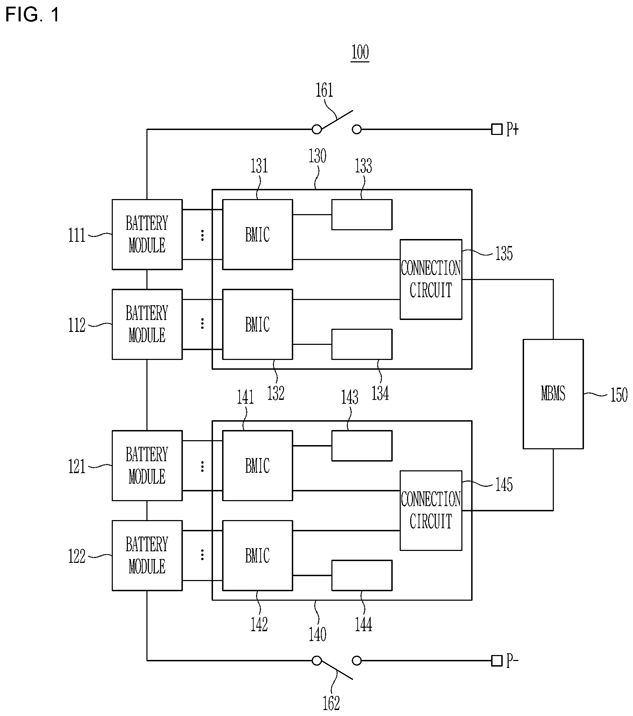

FIG. 1 is a block diagram of a battery apparatus according to some embodiments.

Referring to FIG. 1, a battery apparatus 100 may include a battery module 111, a cell module controller (CMC) 130, a master battery management system (MBMS) 150, and switches 161 and 162.

The battery apparatus 100 may be connected to an external apparatus via a positive link terminal P+ and a negative link terminal P-. In some embodiments, when the external apparatus is a load, the battery apparatus 100 may be discharged by acting operating as a power supply that supplies power to the load. When the external apparatus is a charger, the battery apparatus 100 may be charged by receiving external power through the charger. In some embodiments, the external apparatus operating as the load may be, for example, an electronic device, a mobility device, or an energy storage system (ESS), and the mobility device may be, for example, a vehicle such as an electric vehicle, a hybrid vehicle, or a smart mobility. The battery apparatus 100 may be referred to as a battery pack.

The battery module 111 may include a plurality of battery cells. In some embodiments, the plurality of battery cells in the battery module 111 may be connected in series. In some embodiments, the battery apparatus 100 may include a plurality of battery modules 111, 112, 121, and 122 as shown in FIG. 1. For convenience, four battery modules 111, 112, 121, and 122 are shown in FIG. 1, but the number of battery modules 111, 112, 121, and 122 is not limited thereto. In some embodiments, the battery modules 111, 112, 121, and 122 may be connected in series or in parallel. For convenience, the battery modules 111, 112, 121, and 122 connected in series are shown in FIG.1.

The cell module controller 130 may monitor information of the battery modules 111 and 112. The cell module controller 130 may be referred to as a cell monitoring unit (CMU), a cell voltage and temperature node (CVTN), a slave battery management system (SBMS), cell supervising electronics (CSE), a cell supervision circuit (CSC), or a cell sensor circuit (CSC). In some embodiments, the battery apparatus 100 may include a plurality of cell module controllers 130 and 140 as shown in FIG. 1. The two cell module controllers 130 and 140 are shown in FIG. 1 for convenience, but the number of cell module controllers 130 and 140 is not limited thereto. In this case, the cell module controller 130 may monitor information of the corresponding battery modules 111 and 112, and the cell module controller 140 may monitor information of the corresponding battery modules 121 and 122.

Each of the cell module controllers 130 and 140 may be formed on a printed circuit board (PCB). The cell module controller 130 may include one or more battery monitoring integrated circuits (BMICs) 131 and 132, and the cell module controller 140 may also include one or more BMICs 141 and 142. In some embodiments, the BMICs 131 and 132 may correspond to the battery modules 111 and 112, respectively, and the BMICs 141 and 142 may correspond to the battery modules 121 and 122, respectively. In some embodiments, one BMIC (e.g., 131) may correspond to two or more battery modules (e.g., 111 and 112), or two or more BMICs (e.g., 131 and 132) may correspond to one battery module (e.g., 111). In some embodiments, each of the BMICs 131, 132, 141, and 142 may perform sensing of voltages of battery cells included in a corresponding one of battery modules 111, 112, 121, and 122, sensing of a temperature of the corresponding one of the battery module 111, 112, 121, and 122, balancing of the battery cells, and the like.

In some embodiments, the cell module controllers 130 and 140 may further include connection circuits 135 and 145, respectively. The connection circuits 135 and 145 may transmit the monitored information of the battery module to the master battery management system 150 and receive a control signal from the master battery management system 150. In some embodiments, the connection circuits 135 and 145 may connect the cell module controllers 130 and 140 and the master battery management system 150 via wired communication. In some embodiments, the connection circuits 135 and 145 may connect the cell module controllers 130 and 140 and the master battery management system 150 via wireless communication.

The master battery management system 150 may measure information of the battery modules 111, 112, 121, and 122 or control the cell module controllers 130 and 140 based on the information received from the cell module controllers 130 and 140. The master battery management system 150 may output a control signal to control the switches 161 and 162.

The switch 161 may be connected between a positive terminal of the battery module 111 and the positive link terminal P+, and the switch 162 may be connected between a negative terminal of the battery module 122 and the negative link terminal P-. The switches 161 and 162 may be controlled by the master battery management system 150 to control a connection between the battery apparatus 100 and the external apparatus. In some embodiments, the switches 161, 162 may each include a contactor comprising a relay. In some embodiments, the switches 161, 162 may each include an electrical switch, such as a transistor. In some embodiments, the battery apparatus 100 may further include a drive circuit (not shown) that drives the switches 161 , 162, respectively, in response to a control signal from the master battery management system 150.

The cell module controllers 130 and 140 may further include leakage detection circuits 133, 134, 143, and 144 that detect a leakage in the battery apparatus 100. The leakage detection circuit (e.g., 133) may provide a voltage determined based on the leakage in the battery apparatus 100 to a BMIC (e.g., 131) formed in the corresponding cell module controller (e.g., 130). Although FIG. 1 shows that one leakage detection circuit 133, 134, 143, or 144 is connected to each of the BMICs 131, 132, 141, and 142, a connection relationship is not limited thereto. In some embodiments, the leakage detection circuit(s) may be formed in only some of the plurality of cell module controllers 130 and 140. In some embodiments, the leakage detection circuit(s) may be connected to only some of the plurality of BMICs 131, 132, 141, and 142. In some embodiments, a plurality of leakage detection circuits may be connected to one BMIC.

In some embodiments, when the PCBs on which the cell module controllers 130 and 140 are formed is conformally coated, some areas (exposed areas) of the PCB may not be conformally coated and expose a conductive material (e.g., copper). The leakage detection circuits 133, 134, 143, and 144 may be formed in the areas where the conductive material is exposed. When the leakage occurs in the battery apparatus 100, the leakage may contact the exposed conductive material, a resistance of a resistor formed on the conductive material may change due to the contact of the leak, and the leakage detection circuit (e.g., 133) may provide the corresponding BMIC (e.g., 131) with a voltage that changes depending on the change in the resistance. In some embodiments, the BMIC 131 may determine whether there is the leakage, based on a magnitude of the voltage. In some embodiments, the BMIC 131 may transfer information indicating the voltage to the master battery management system 150, and the master battery management system 150 may determine whether there is the leakage based on the magnitude of the voltage.

As described above, the unit cost of the leakage detection circuit may be reduced by implementing the leakage detection circuit using the conductive material on the PCB rather than using a separate sensor. Further, by forming the leakage detection circuit in the cell module controller rather than in the master battery management system, only the BMIC may wake up to detect the leakage when the battery apparatus is in a sleep mode.

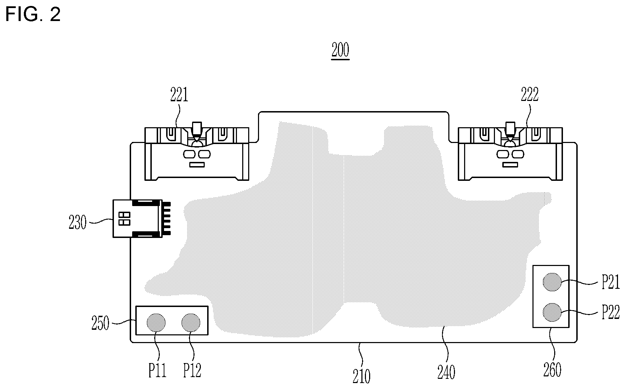

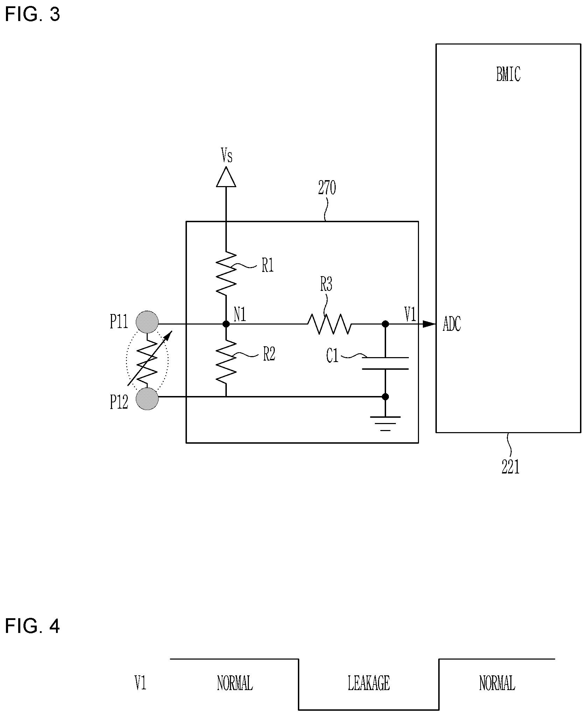

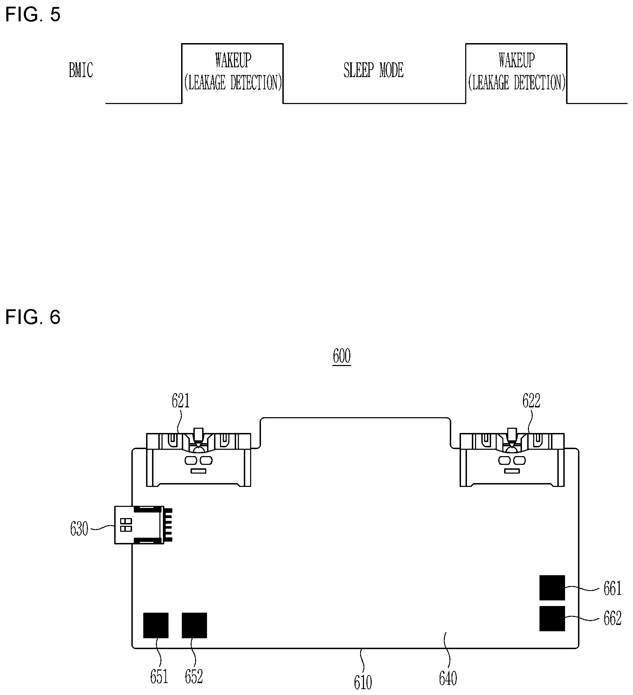

FIG. 2 is a drawing illustrating a PCB assembly of a cell module controller according to some embodiments, FIG. 3 is a drawing illustrating a leakage detection circuit of a cell module controller according to some embodiments, FIG. 4 is a drawing illustrating leakage detection in a battery apparatus according to some embodiments, and FIG. 5 is a drawing illustrating leakage detection in a sleep mode of a battery apparatus according to some embodiments.

Referring to FIG. 2, a surface of a PCB 210 may be conformally coated. In other words, the surface of the PCB 210 on which circuits plated with a conductive material (e.g., copper foil) are formed may be coated with a coating solution (e.g., photo solder resist (PSR) coating solution) 240. Further, BMICs 221 and 222 may be formed on the PCB 210. In some embodiments, a connection circuit 230 for communication with a master battery management system may be formed on the PCB 210. As such, a PCB assembly 200 corresponding to a cell module controller may be implemented by forming the BMICs 221 and 222 and the connection circuit 230 on the PCB 210.

In this case, some areas (one or more areas) 250 and 260 may expose the conductive material without being coated with the coating solution 240. In some embodiments, some areas 250 and 260 may be areas where a leakage is likely to occur. While FIG. 2 shows the two areas 250 and 260 exposing the conductive material, the number of areas 250 and 260 is not limited thereto. Two or more points P11 and P12 can be set in the area 250, and two or more points P21 and P22 may be set in the area 260. In some embodiments, test points used for testing the PCB assembly 200 may be set as the points P11, P12, P21, and P22.

If a leakage occurs in the area 250, a resistance between the points P11 and P12 may increase. In some cases, the resistance between the points P11 and P12 may increase such that is an open circuit may be formed between points P11 and P12. Similarly, if a leakage occurs in the area 260, a resistance between the points P21 and P22 may increase, or an open circuit may be formed between the points P21 and P22. Accordingly, the BMIC 221 corresponding to the area 250 may receive a voltage determined based on the resistance between the points P11 and P12, and the BMIC 222 corresponding to the area 260 may receive a voltage determined based on the resistance between the points P21 and P22. A leakage detection circuit may be connected to the points P11 and P12 to determine the voltage based on the resistance between the points P11 and P12, and a leakage detection circuit may be connected to the points P21 and P22 to determine the voltage based on the resistance between the points P21 and P22. In some embodiments, the BMICs 221 and 222 may determine whether there is the leakage based on the received voltage. In some embodiments, the BMICs 221 and 222 may transfer information indicating the received voltage to a master battery management system, and the master battery management system may determine whether there is the leakage based on the received voltage.

Referring to FIGS. 2 and 3, a leakage detection circuit 270 may include resistors R1 and R2 connected in series. The resistors R1 and R2 may be formed on an area of the PCB 210, which is coated with the coating solution 240. The resistors R1 and R2 may be connected in series between a terminal supplying a predetermined voltage Vs and a terminal having a potential lower than the predetermined voltage Vs. In some embodiments, the terminal having the potential lower than the predetermined voltage Vs may be a ground terminal. The leakage detection circuit 270 may transfer a voltage corresponding to a contact (or node) N1 of the resistors R1 and R2 to the BMIC 221 as a detection voltage V1. One terminal (or first terminal) N1 of the resistor R2 may be connected to a point P11 of the points P11 and P12 via a line (or first line), and the other terminal (or second terminal) of the resistor R2 may be connected to the other point P12 via a line (or second line). In other words, the resistor R2 may be connected between the first line and the second line. The resistor R1 may be connected between the terminal supplying the predetermined voltage Vs and the first line (the first terminal N1 of the resistor R2). The area between the two points P11 and P12 may be represented as a variable resistor because a resistance of the area changes due to the leakage.

In this case, if there is no leakage in the area where the points P11 and P12 are set, the voltage V1 at the contact N1 of the two resistors R1 and R2 may approximate the voltage Vs because the resistance between the points P11 and P12 is very small due to the conductive material. For example, if the voltage Vs is 5 V, the voltage V1 at contact N1 of the resistors R1 and R2 can be 4 to 4.5 V. If the leakage occurs in the area where the points P11 and P12 are set, the voltage V1 at the contact N1 of the two resistors R1 and R2 may be a voltage at which the Vs voltage is divided by the resistors R1 and R2 because the resistance between the points P11 and P12 is very large due to the leakage. For example, if the voltage Vs is 5 V, the voltage V1 at the contact N1 of the resistors R1 and R2 may be 1 to 3.5 V.

Thus, as shown in FIG. 4, the BMIC 221 or the master battery management system may determine whether there is the leakage based on the detection voltage V1 of the leakage detection circuit 270. In some embodiments, if the detection voltage V1 is higher than a first voltage, the BMIC 221 or the master battery management system may determine a normal state where there is no leakage. If the detection voltage V1 is lower than a second voltage, the BMIC 221 or the master battery management system may determine that the leakage has occurred. In this case, the second voltage may be lower than or equal to the first voltage.

In some embodiments, the detection voltage V1 of the leakage detection circuit 270 may be input to a predetermined pin of the BMIC 221 (e.g., an analog-to-digital (ADC) pin). The BMIC 221 may convert the voltage V1 received at the ADC pin to a digital signal.

In some embodiments, the leakage detection circuit 270 may further include a resistor R3 connected between the contact N1 of the resistors R1 and R2 and the ADC pin of the BMIC 221. The resistor R3 may limit current input to the BMIC 221. In some embodiments, the leakage detection circuit 270 may further include a capacitor C1 connected between the ADC pin and a ground terminal. The capacitor C1 may perform noise filtering. The resistor R3 and the capacitor C1 may be formed on the area of the PCB 210 coated with the coating solution 240.

In some embodiments, as shown in FIG. 5, when the battery apparatus has entered a sleep mode, the BMIC 221 may periodically (at predetermined intervals) wake up to detect whether there is the leakage. The BMIC 221 may wake up at predetermined intervals to receive the detection voltage V1 through the predetermined pin. If the leakage is detected, the BMIC 221 may wake up the master battery management system. In some embodiments, the master battery management system may send a warning signal to an external apparatus (e.g., a vehicle) to which the battery apparatus is connected, or may enter a safe state that prevents the switches (e.g., 161 and 162 in FIG. 1) from closing.

FIG. 6 is a diagram illustrating a PCB assembly of a cell module controller according to some embodiments.

Referring to FIG. 6, a PCB assembly 600 may include BMICs 621 and 622 and a connection circuit 630 formed on the PCB 610 as described with reference to FIG. 2. A surface of the PCB 610 may be coated with a coating solution (e.g., a PSR coating solution) 640. In this case, some areas where points for leakage detection are set in the surface of the PCB 610 may expose a conductive material without being coated with the coating solution 640.

When the points are exposed, contamination may occur on the points. In this case, the leakage may not be normally detected on the points due to the contamination. In some embodiments, elements 651, 652, 661, and 662 may be mounted on the points to prevent the contamination at the points.

In some embodiments, the elements 651, 652, 661, and 662 may include surface mount technology (SMT) contact pads connected to the points.

In some embodiments, the elements 651, 652, 661, and 662 may include pogo pins connected to the points.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A cell module controller configured to monitor a battery module included in a battery pack, the cell module controller comprising:
a printed circuit board coated with a coating solution, except for an exposed area comprising a first point and a second point;
a leakage detection circuit formed on the printed circuit board, and comprising at least one resistor connected to the first point and the second point via a line; and
a battery monitoring integrated circuit formed on the printed circuit board, and configured to receive a detection voltage at a predetermined pin, the detection voltage being determined based on a resistance between the first point and the second point determined based on whether there is a leakage within the battery pack, and the at least one resistor.

2. The cell module controller of claim 1, wherein the line comprises a first line connected to the first point and a second line connected to the second point,
wherein the at least one resistor comprises:
a first resistor connected between a terminal supplying a predetermined voltage and the first line; and
a second resistor connected between the first line and the second line, and
wherein the leakage detection circuit is configured to output a voltage at a contact of the first resistor and the second resistor as the detection voltage.

3. The cell module controller of claim 2, wherein the leakage detection circuit further comprises a third resistor connected between the contact and the predetermined pin.

4. The cell module controller of claim 2, wherein the leakage detection circuit further comprises a capacitor connected between the predetermined pin and a ground terminal.

5. The cell module controller of claim 2, wherein the battery monitoring integrated circuit is further configured to:
receive the detection voltage that is higher than a first voltage when no leakage occurs in the battery pack; and
receive the detection voltage that is lower than a second voltage when the leakage occurs in the battery pack.

6. The cell module controller of claim 5, wherein the second voltage is lower than or equal to the first voltage.

7. The cell module controller of claim 1, further comprising elements mounted on the first point and the second point.

8. The cell module controller of claim 7, wherein the elements comprise surface mount technology (SMT) contact pads.

9. The cell module controller of claim 7, wherein the elements comprise pogo pins.

10. The cell module controller of claim 1, wherein the battery monitoring integrated circuit is further configured to periodically wake up to receive the detection voltage when the battery apparatus has entered a sleep mode.

11. A battery apparatus comprising:
a battery module;
a cell module controller configured to monitor the battery module; and
a master battery management system configured to control the cell module controller, and receive information monitored by the cell module controller,
wherein the cell module controller comprises:
a printed circuit board coated with a coating solution, except for an exposed area comprising a first point and a second point;
a first resistor and a second resistor formed on the printed circuit board, and connected in series between a terminal supplying a predetermined voltage and a terminal having a potential lower than the predetermined voltage, two terminals of the second resistor being connected to the first point and the second point, respectively; and
a battery monitoring integrated circuit formed on the printed circuit board, and configured to receive a voltage at a contact of the first resistor and the second resistor as a detection voltage for detecting a leakage.

12. The battery apparatus of claim 11, wherein the battery monitoring integrated circuit is further configured to:
determine that no leakage occurs in the battery apparatus in response to the detection voltage being higher than a first voltage; and
determine that the leakage occurs in the battery apparatus in response to the detection voltage being lower than a second voltage.

13. The battery apparatus of claim 11, wherein the battery monitoring integrated circuit is further configured to transfer information indicating the detection voltage to the master battery management system, and
wherein the master battery management system is further configured to:
determine that no leakage occurs in the battery apparatus in response to the detection voltage being higher than a first voltage; and
determine that the leakage occurs in the battery apparatus in response to the detection voltage being lower than a second voltage.

14. The battery apparatus of claim 11, wherein the master battery management system is further configured to, when the leakage occurs in the battery apparatus, send a warning signal to an external apparatus to which the battery apparatus is connected.

15. The battery apparatus of claim 11, further comprising a switch configured to control an electrical connection between the battery module and an external apparatus,
wherein the master battery management system is further configured to, when the leakage occurs in the battery apparatus, prevent the switch from closing.

16. The battery apparatus of claim 11, wherein the battery monitoring integrated circuit is further configured to, when the battery apparatus has entered a sleep mode, periodically wake up to receive the detection voltage.
